# EUROPÄISCHE PATENTSCHRIFT

(11) **EP 3 997 476 B1**
(45) Veröffentlichungstag und Bekanntmachung des Hinweises auf die Patenterteilung: **07.08.2024**
(21) Anmeldenummer: 20734919.2
(22) Anmeldetag: 25.06.2020
(51) Int. Cl.: G01S 7/00, G01S 13/931, G01S 15/931, G01S 17/931

(54) **SICHTBAUTEIL MIT FUNKTIONALER BESCHICHTUNG**
VISIBLE COMPONENTS WITH FUNCTIONAL COATING
COMPOSANT VISIBLE À REVÊTEMENT FONCTIONNEL

(30) Priorität: 12.07.2019 DE 102019210315
(43) Veröffentlichungstag der Anmeldung: 18.05.2022
(73) Patentinhaber: Audi AG, 85045 Ingolstadt (DE)
(72) Erfinder: STOHLER, Frank, 75248 Ölbronn-Dürrn (DE); BELKHOFER, Peter, 85110 Kipfenberg (DE)
(86) Internationale Anmeldenummer: PCT/EP2020/067849
(87) Internationale Veröffentlichungsnummer: WO 2021/008849

(56) Entgegenhaltungen:
- EP-A1- 3 435 874
- WO-A1-2019/020716
- DE-A1- 102006 017 178
- DE-A1- 102017 205 192
- US-A1- 2003 111 902

## Beschreibung

Die vorliegende Erfindung betrifft Sichtbauteile mit funktionaler Beschichtung im Innen- und Außenbereich von Kraftfahrzeugen und Verfahren zu ihrer Herstellung.

Aktuell werden Sensoren und Kameras als eigenständige Bauteile in und am Fahrzeug angebracht. Diese Systeme nehmen sehr viel Platz in Anspruch, sind teuer und somit sehr aufwändig für den Austauschfall. Die Konnektivität und die Verbindung zu einer nachgelagerten Recheneinheit erfolgen über Kabel. Diese Komponenten sind zwingend erforderlich für sämtliche Assistenzsysteme in einem Fahrzeug, beginnend bei Parksensoren, über Spurhalte- und Abstandssensoren, bis zu Komponenten für das autonome Fahren. Variantenvielfalt und Kosten sind hoch, es sind für fast jeden Anwendungsfall unterschiedliche Technologien notwendig. So ist z.B. ein Parksensor lediglich ein einfacher Abstandssensor, während man für eine Verkehrsschildererkennung Kameras benötigt, für eine Abstandsregelung oder einen Notbremsassistenten sogar eine Kombination aus Kamera und Radarsensor. Ein konventioneller Radarsensor liefert lediglich eine Distanz sowie einen Winkel. Dies bedeutet, dass lediglich die Information vorliegt, dass sich im Sichtbereich des Sensors etwas befindet. Deshalb werden zusätzlich Kameras verbaut.

Üblicherweise sind nahezu keine Redundanzsysteme vorhanden. Fällt eine Kamera aus, oder ein Radarsensor, oder die Kabelverbindung zu einer nachgelagerten Recheneinheit, so ist die Funktionalität zumeist nicht mehr gegeben. Bei Reparaturen sind hohe und komplexe Anforderungen zu erfüllen. Häufig müssen die Ersatzteile neu kalibriert werden, da die getauschten Bauteile sicherheitsrelevante Funktionen haben.

Die DE 10 2017 212 784 A1 offenbart ein Zierteil für ein Fahrzeug, das mindestens eine integrierte Leiterplatte umfasst, die vollständig von mindestens einer thermoplastischen Komponente und/oder mindestens einem duroplastischen Lack umgeben ist. Die Integration der Leiterplatte in das Zierteil ermöglicht es, dass keine zusätzlichen und zierteilexternen Bauräume und damit verbundene aufwändige elektrische und signaltechnische Kopplungen des Zierteils und der Leiterplatte erforderlich sind. In einer Ausgestaltung umfasst die Leiterplatte zumindest ein elektronisches Bauteil, welches ein optischer Sensor, beispielsweise ein Infrarotsensor oder Lidarsensor, ein akustischer Sensor, beispielsweise ein Ultraschallsensor, ein elektromagnetischer Sensor, beispielsweise ein induktiver Sensor, kapazitiver Sensor oder Radarsensor, ein Beschleunigungssensor, ein Geschwindigkeitssensor, ein Temperatursensor, Feuchtigkeitssensor oder Helligkeitssensor und/oder eine Lichtquelle, beispielsweise zur Darstellung von Logos, Schriftzügen, Symbolen, Formen oder technischen Strukturen, sein kann.

Aus der DE 10 2015 216 793 A1 ist ein Sensor zur Aufprallerkennung für ein Fahrzeug bekannt, der einen elektrisch leitfähigen Erfassungsbereich aufweist, an den für eine kontinuierliche Spannungs- und/oder WiderstandsMessung eine Spannung angelegt wird. Der Erfassungsbereich ist ein verformbarer Kunststoffkörper mit einem perkolierenden Netzwerk aus einem elektrisch leitfähigen Füllstoff. Der Erfassungsbereich ist so gestaltet, dass durch einen Aufprall eines Objekts auf den Erfassungsbereich eine Spannungs- und/oder Widerstandsänderung hervorgerufen wird.

Die EP 1 654 726 B1 betrifft einen Sensor für ein Parksystem und/oder ein Nahbereichserfassungssystem eines Kraftfahrzeugs, insbesondere einen Ultraschallsensor. Der Sensor weist ein topfförmiges Gehäuse auf, dessen Boden als Schwingmembran ausgebildet ist. Das Gehäuse weist zumindest an der Außenseite eine Beschichtung auf, die aus wetterfestem Pulver besteht, das emailliert werden kann und das Schwingungsverhalten der Membran nicht oder nicht wesentlich negativ beeinflusst.

Die DE 103 17 638 A1 offenbart eine Anordnung zur Aufprallerkennung mit Aufprallsensoren an der Außenseite eines Kraftfahrzeugs und einem druckempfindlichen Lack an der Kraftfahrzeugkarosserie in Kontakt mit einem Aufprallsensor, der in Abhängigkeit von dem ausgeübten Druck einen elektrischen Parameter verändert.

Die DE 10 2011 010 861 A1 lehrt ein Verfahren zur Analyse und Optimierung von Radomen für einen Kraftfahrzeug-Radarsensor. Das Verfahren umfasst eine qualitative und eine quantitative Analyse des radarperiodischen Übertragungsverhaltens von Lack- und Kunststoffteilen zur Herstellung von Radommodellen. Die Radommodelle werden auf Basis der Ergebnisse der qualitativen und quantitativen Analyse der Lack- und Kunststoffkomponenten einem Simulationsprozess unterzogen. Ein optimiertes Radommodell wird auf der Grundlage des radarperiodischen Übertragungsverhaltens und des Reflexionsverhaltens der Lackkomponenten und der Kunststoffkomponenten ausgewählt. Das Radom wird durch ein Kraftfahrzeugbauteil gebildet, z.B. Stoßstange und Verkleidung.

Aus der DE 10 2008 036 012 A1 geht ein Radom für einen Radarsensor in einem Kraftfahrzeug hervor, dessen Wand aus wenigstens zwei Schichten besteht. Auf einer Seite der Wand oder zwischen zwei Kunststoffschichten ist wenigstens eine induktiv oder kapazitiv wirkende Vorrichtung angeordnet, die eine von der Lackschicht hervorgerufene Reflexion der elektromagnetischen Strahlung des Radarsensors wenigstens teilweise kompensiert.

Die DE 10 2006 017 178 A1 betrifft ein Fahrerassistenzsystem für Kraftfahrzeuge, mit mindestens einem Sensor zur Erfassung des Verkehrsumfelds und einer zugehörigen Auswerteeinheit mit einer Benutzerschnittstelle, in dem der Sensor und die Auswerteeinheit über drahtlose Kommunikationsschnittstellen miteinander verbunden sind.

Die EP 3 435 874 A1 betrifft ein System zur Positionsbestimmung eines RF Transponderschaltkreises oder einer Ultraschallemittereinheit. Der RF Transponderschaltkreis emittiert RF Signale, die auf Basis empfangener Ultraschallsignale moduliert werden, die von der Ultraschallemittereinheit emittiert oder reflektiert werden. Die Position des RF Transponderschaltkreises bzw. der Ultraschallemittereinheit wird aus einer Zeitdifferenz zwischen der Emission eines Ultraschallsignals durch die Ultraschallemittereinheit und der Detektion durch die RF Detektoreinheit einer korrespondierenden Modulation des von dem RF Transponderschaltkreis emittierten oder reflektierten RF Signals ermittelt.

In der DE 10 2017 205 192 A1 wird ein handgehaltenes Laserentfernungsmessgerät zur berührungslosen Entfernungsmessung zwischen dem Laserentfernungsmessgerät und einem entfernten Gegenstand unter Verwendung eines von dem Laserentfernungsmessgerät emittierbaren Laserstrahls vorgeschlagen. Das Laserentfernungsmessgerät weist dem Gerätegehäuse zugeordnet eine geräteseitige Koppelvorrichtung auf, die zur reversiblen Anordnung zumindest einer Aufsatzvorrichtung an dem Laserentfernungsmessgerät eingerichtet ist, wobei durch Anordnung der Aufsatzvorrichtung an dem Laserentfernungsmessgerät zumindest eine Zusatzfunktionalität bereitstellbar ist.

Die WO 2019 / 020 716 A1 betrifft ein Zierteil für ein Fahrzeug mit zumindest einer integrierten Leiterplatte, welche vollständig von zumindest einer thermoplastischen Komponente und/oder zumindest einem duroplastischen Polymer umgeben ist.

Vor diesem Hintergrund hat sich die vorliegende Erfindung die Aufgabe gestellt, Sensorik-Funktionen aufweisende Sichtbauteile für den Innen- und Außenbereich von Kraftfahrzeugen bereitzustellen, die variabel gestaltet und eingesetzt werden können und kostengünstig herstellbar sind.

Die Aufgabe wird erfindungsgemäß gelöst durch eine Vorrichtung mit den Merkmalen des Anspruchs 1 sowie ein Verfahren mit den Merkmalen des Anspruchs 11. Ausgestaltungen und Weiterbildungen der Erfindung ergeben sich aus den abhängigen Ansprüchen.

Gegenstand der Erfindung ist ein Sichtbauteil für ein Kraftfahrzeug, umfassend einen Grundkörper mit einer Sichtoberfläche und wenigstens ein Sensorelement auf der Sichtoberfläche des Grundkörpers. Das wenigstens eine Sensorelement ist elektrisch mit einem an das mindestens eine Sensorelement angrenzenden Element zur drahtlosen Datenübertragung verbunden, durch das Messdaten des Sensorelementes drahtlos an eine Auswerteeinheit übermittelbar sind. Erfindungsgemäß ist das wenigstens eine Sensorelement mit dem Element zur drahtlosen Datenübertragung über Verstärkungs- und/oder Vorverarbeitungsschaltungen verbunden und das Element zur drahtlosen Datenübertragung ist durch ein induktives Aktivierungselement energetisierbar. Auf den Grundkörper sind Schichten aufgebracht mit der Abfolge a) eine mindestens ein Element zur drahtlosen Datenübertragung enthaltende Schicht; b) eine mindestens eine Signalverstärkungsschaltung enthaltende Schicht; c) eine mindestens eine Signalverarbeitungsschaltung enthaltende Schicht; d) eine mindestens ein Sensorelement enthaltende Schicht; e) gegebenenfalls eine mindestens einen Wellenlängenmodulator enthaltende Schicht; und f) gegebenenfalls eine Verkapselung.

In einer Ausführungsform ist das Element zur drahtlosen Datenübertragung ein passiver RFID Transponder. In einer anderen Ausführungsform ist das Element zur drahtlosen Datenübertragung ein NFC-Chip. In einer anderen Ausführungsform ist das Element zur drahtlosen Datenübertragung für kabellose optische Datenübertragung (Optical Wireless Communication, OWC) konfiguriert.

Das wenigstens eine Sensorelement ist mit dem Element zur drahtlosen Datenübertragung über Verstärkungs- und/oder Vorverarbeitungsschaltungen verbunden.

In einer Ausführungsform des Sichtbauteils befindet sich auf dem wenigstens einen Sensorelement ein Wellenlängenmodulator. In einer Ausführungsform ist dies ein Wellenlängenmodulator für Radar. In einer anderen Ausführungsform ist dies ein Wellenlängenmodulator für IR. Für sichtbares Licht ist kein Modulator erforderlich.

In einer weiteren Ausführungsform weist das wenigstens eine Sensorelement eine diffusionsdichte Verkapselung auf. Die diffusionsdichte Verkapselung schließt in einer Ausführungsform einen Wellenlängenmodulator mit ein. Die Verkapselung kann mit Parylene, SiOₓ oder auch mit Spinell (MgAl₂O₄) für eine größere Härte (Faktor 150 zu normalem Glas) ausgeführt werden.

Das erfindungsgemäße Sichtbauteil kann sowohl im Außenbereich eines Fahrzeugs als auch im Innenbereich, z.B. zur Innenraumüberwachung, eingesetzt werden. In einer Ausführungsform ist der Grundkörper des Sichtbauteils ein Bauteil für den Außenbereich eines Kraftfahrzeugs, beispielsweise ein Karosseriebauteil, insbesondere ein Stoßfänger; ein Kühlergrill; eine Front- oder Heckscheibe. In einer anderen Ausführungsform ist der Grundkörper des Sichtbauteils ein Bauteil für den Innenbereich eines Kraftfahrzeugs. In einer weiteren Ausführungsform ist der Grundkörper eine Folie, insbesondere eine selbstklebende oder magnetische Folie.

Über den passiven RFID Transponder, welcher als gedruckte Schaltung unter bzw. hinter das wenigstens eine Sensorelement integriert wird (gemeinsam auch als "Sensorikschicht" bezeichnet), erfolgt eine kabellose Datenübertragung zu einer nachgelagerten Recheneinheit. Durch die kabellose Datenübertragung ist keine physikalische Anbindung (Kabelverbindung, Elektroden) an eine nachgelagerte Recheneinheit notwendig.

Die nachgelagerte Datenverarbeitung erfolgt in dem Fachmann im Prinzip bekannter Weise. In einer Ausführungsform des erfindungsgemäßen Sichtbauteils ist das mindestens eine Sensorelement dafür eingerichtet, eine Datenvorverarbeitung durchzuführen, durch die das zu übertragende Datenvolumen auf die relevanten Daten reduziert wird.

In einer Ausführungsform des Sichtbauteils ist der passive RFID Transponder auf die Sichtoberfläche gedruckt. In einer anderen Ausführungsform ist der passive RFID Transponder auf eine Trägerfolie aufgedruckt, welche auf der Sichtoberfläche angeordnet ist. Die Trägerfolie kann insbesondere eine Folie sein, wie sie heute für komplette Folierungen zur Farbgebung Verwendung findet.

Der RFID Chip ist durch ein induktives Aktivierungselement energetisierbar, d. h. die Spannungsversorgung des passiven RFID Transponders und des wenigstens einen Sensorelements (der "Sensorikschicht") erfolgt über eine induktive Spannungsversorgung. In einer Ausführungsform wird mehr als eine induktive Spannungsversorgung eingesetzt. Dadurch wird eine grundlegende Voraussetzung für die Sicherheit bei autonomem Fahren erfüllt (Berücksichtigung gesetzlicher Vorgaben). Durch eine mehrfache Spannungsversorgung über Induktionssender werden sicherheitsrelevante Redundanzen für autonomes Fahren bereitgestellt.

In einer Ausführungsform des Sichtbauteils ist das wenigstens eine Sensorelement auf die Sichtoberfläche gedruckt. In einer anderen Ausführungsform ist das wenigstens eine Sensorelement auf eine Trägerfolie aufgedruckt, welche auf der Sichtoberfläche angeordnet ist.

In einer Ausführungsform des Sichtbauteils ist das wenigstens eine Sensorelement zur Rezeption von Strahlung vorgesehen. In einer Ausführungsform handelt es sich bei der Strahlung um Infrarotstrahlung. In einer anderen Ausführungsform handelt es sich bei der Strahlung um Radarwellen. In wieder einer anderen Ausführungsform handelt es sich bei der Strahlung um Strahlung im sichtbaren Bereich.

In einer Ausführungsform des Sichtbauteils umfasst das wenigstens eine Sensorelement ein organisches Polymer. Moderne Sensormaterialien bestehen meist aus organischen Polymeren. Diese können mit unterschiedlichen Verfahren hergestellt werden. Notwendige elektronische Schaltungen können gedruckt werden.

Durch eine geeignete Wellenlängenmodulation können Bereiche eingebracht werden, die für unterschiedliche Wellenlängen sensitiv sind (z.B. Radar und Infrarot). So lassen sich Sensoren für unterschiedliche Wellenlängenbereiche unter Verwendung derselben Fertigungstechnologie herstellen. Die Sensoren (z.B. für Radar und IR) basieren jeweils auf dem gleichen Grundprinzip organischer Materialien.

In einer Ausführungsform umfasst das Sichtbauteil wenigstens zwei Sensorelemente, die für die Rezeption von Strahlung unterschiedlicher Wellenlängenbereiche eingerichtet sind (z.B. ein Sensorelement für Radar und ein Sensorelement für Infrarot).

In einer Ausführungsform ist das mindestens eine Sensorelement flächig ausgeführt und weist eine Dicke von maximal 1 bis 2 µm auf. In einer Ausführungsform besteht das mindestens eine Sensorelement aus mehreren Schichten, die jeweils eine Dicke von weniger als 1 µm aufweisen. In einer Ausführungsform besteht das mindestens eine Sensorelement aus fünf Schichten. Die flächige Anordnung des wenigstens einen Sensorelements ermöglicht eine neue Designsprache, da die bei üblichen elektronischen Bauteilgruppen vorhandenen geometrischen Limitierungen wegfallen. Die einzelnen Sensorelemente können nach Belieben rund um ein Fahrzeug angeordnet werden, und es können beliebige Freiformflächen realisiert werden.

In einer speziellen Ausführungsform sind der passive RFID Transponder und das mindestens eine Sensorelement auf einer selbstklebenden Folie angeordnet, die als "mobiler Sensor" nur temporär an ein Fahrzeug angebracht wird.

Erfindungsgemäß ist insbesondere die Integration sensoraktiver Materialien in Beschichtungssysteme, insbesondere Lacksysteme, vorgesehen. Bringt man die erfindungsgemäßen Sensorelemente aus organischen Polymeren in Lacksysteme ein, z.B. an der Frontseite oder an Kotflügeln des Fahrzeugs, kann man sie anschließend mit dem Deck- und/oder Klarlack der Fahrzeuglackierung überziehen und so unter die Deck- und/oder Klarlackschicht bringen. Sie sind dann vor Umwelteinflüssen geschützt. Durch die Einbringung in ein außenliegendes Lacksystem werden zudem Grenzflächen vermieden, die zu unerwünschten Signalschwächungen und Signalveränderungen durch Brechung, Beugung, Streuung, etc. führen.

In einer Ausführungsform des Sichtbauteils sind das wenigstens eine Sensorelement und die Sichtoberfläche des Grundkörpers zumindest teilweise von einer gemeinsamen Lage eines Beschichtungsmaterials überzogen. In einer weiteren Ausführungsform sind das wenigstens eine Sensorelement und die Sichtoberfläche des Grundkörpers vollständig mit Beschichtungsmaterial überzogen.

Gegenstand der Erfindung ist auch ein Verfahren zur Herstellung des erfindungsgemäßen Sichtbauteils, worin auf einen Grundkörper eine Abfolge von Schichten aufgebracht wird, wobei die Abfolge
a) eine mindestens ein Element zur drahtlosen Datenübertragung enthaltende Schicht;
b) eine mindestens eine Signalverstärkungsschaltung enthaltende Schicht;
c) eine mindestens eine Signalverarbeitungsschaltung enthaltende Schicht;
d) eine mindestens ein Sensorelement enthaltende Schicht;
e) gegebenenfalls eine mindestens einen Wellenlängenmodulator enthaltende Schicht; und
f) gegebenenfalls eine Verkapselung
umfasst.

In einer Ausführungsform des Verfahrens durchläuft der Grundkörper zunächst die im Prinzip bekannten Prozessschritte zur Lackiervorbereitung wie Waschen, Beizen, Passivieren oder Plasmaaktivieren; und wird anschließend mit einem Lackfüller versehen.

Auf den Grundkörper wird die Sensorikschicht aufgebracht, in nachfolgender Reihenfolge:
1. mindestens ein Element zur drahtlosen Datenübertragung wird als gedruckter Schaltkreis aufgebracht;
2. es werden Signal-Verstärkungsschaltungen und/oder -Vorverarbeitungsschaltungen aufgebracht;
3. es wird mindestens ein Sensorelement aufgebracht;
4. gegebenenfalls wird ein Wellenlängenmodulator aufgebracht;
5. gegebenenfalls erfolgt eine Verkapselung.

In einer Ausführungsform erfolgt das Aufbringen von Signal-Verstärkungsschaltungen und/oder Signal-Vorverarbeitungsschaltungen über physikalische Gasphasenabscheidung (Physical Vapor Deposition, PVD) oder durch plasmaunterstützte chemische Gasphasenabscheidung (Plasma-Assisted Chemical Vapor Deposition, PACVD).

In einer Ausführungsform erfolgt das Aufbringen der Sensorelemente durch PVD oder PACVD. In einer anderen Ausführungsform erfolgt das Aufbringen der Sensorelemente durch Aufdrucken.

In einer Ausführungsform werden die Sensorelemente als OLED aufgebaut und umfassen 3 bis 5 Schichten. In einer Ausführungsform umfassen die Schichten zwei als Elektroden wirkende Schichten. Die Herstellung derartiger Sensorelemente ist beschrieben in DE 10 2018 100728 A1.

In einer Ausführungsform wird ein Wellenlängenmodulator aufgebracht, beispielsweise für Radar oder für IR. Für sichtbares Licht ist kein Modulator erforderlich.

Falls notwendig, wird zusätzlich eine diffusionsdichte Verkapselung aufgebracht.

In einer Ausführungsform des Verfahrens werden die Bauteile anschließend wieder in den normalen Lackierprozess zurückgeführt, je nach Notwendigkeit in den Base Coat oder Clear Coat. Falls es sich um ein nicht lackiertes Bauteil handelt (Kühlergrill, Innenseite einer Frontscheibe, mobile Folie etc.) kann das Sichtbauteil direkt der Montage zugeführt werden.

Im erfindungsgemäßen Verfahren beträgt die Dicke einer einzelnen Schicht, unabhängig davon, ob sie durch Drucken oder durch Beschichten hergestellt wird, weniger als 1 µm. Die Dicke des gesamten Schichtaufbaus auf dem Grundkörper, also der Sensorikschicht, beträgt maximal 1 bis 2 µm.

Zu den Vorteilen des erfindungsgemäßen Verfahrens zählt, dass es eine kostengünstige Herstellungsmethode für das erfindungsgemäße Sichtbauteil bereitstellt, insbesondere für den Reparatur- und Austauschfall. Mit dem erfindungsgemäßen Verfahren lassen sich auch Bauteile mit mehreren Sensoren für unterschiedliche Wellenlängenbereiche, insbesondere für sichtbares Licht, IR und Radar, kostengünstig realisieren. Weitere Vorteile und Ausgestaltungen der Erfindung ergeben sich aus der Beschreibung.

## Patentansprüche

1. Sichtbauteil für ein Kraftfahrzeug, umfassend einen Grundkörper mit einer Sichtoberfläche und wenigstens ein Sensorelement auf der Sichtoberfläche des Grundkörpers, wobei das wenigstens eine Sensorelement elektrisch mit einem an das mindestens eine Sensorelement angrenzenden Element zur drahtlosen Datenübertragung verbunden ist, durch welches Messdaten des Sensorelementes drahtlos an eine Auswerteeinheit übermittelbar sind, **dadurch gekennzeichnet, dass** das wenigstens eine Sensorelement mit dem Element zur drahtlosen Datenübertragung über Verstärkungs- und/oder Vorverarbeitungsschaltungen verbunden ist und das Element zur drahtlosen Datenübertragung durch ein induktives Aktivierungselement energetisierbar ist, und dass auf den Grundkörper Schichten aufgebracht sind mit der Abfolge
a) eine mindestens ein Element zur drahtlosen Datenübertragung enthaltende Schicht;
b) eine mindestens eine Signalverstärkungsschaltung enthaltende Schicht;
c) eine mindestens eine Signalverarbeitungsschaltung enthaltende Schicht;
d) eine mindestens ein Sensorelement enthaltende Schicht;
e) gegebenenfalls eine mindestens einen Wellenlängenmodulator enthaltende Schicht; und
f) gegebenenfalls eine Verkapselung.

2. Sichtbauteil nach Anspruch 1 , bei dem das Element zur drahtlosen Datenübertragung auf die Sichtoberfläche des Grundkörpers oder auf eine Trägerfolie, welche auf der Sichtoberfläche angeordnet ist, gedruckt ist.

3. Sichtbauteil nach Anspruch 2, bei dem die Trägerfolie eine selbstklebende oder magnetische Folie ist.

4. Sichtbauteil nach einem der Ansprüche 1 bis 3, bei dem das Element zur drahtlosen Datenübertragung ein passiver RFID Transponder ist.

5. Sichtbauteil nach Anspruch 4, bei dem der passive RFID Transponder als gedruckte Schaltung unter das wenigstens eine Sensorelement integriert ist.

6. Sichtbauteil nach einem der Ansprüche 1 bis 5, bei dem das wenigstens eine Sensorelement zur Rezeption von Strahlung vorgesehen ist.

7. Sichtbauteil nach einem der Ansprüche 1 bis 6, bei dem das wenigstens eine Sensorelement als OLED aufgebaut ist und 3 bis 5 Schichten umfasst.

8. Sichtbauteil nach einem der Ansprüche 1 bis 7, das wenigstens zwei Sensorelemente, die für die Rezeption von Strahlung unterschiedlicher Wellenlängenbereiche eingerichtet sind, umfasst.

9. Sichtbauteil nach einem der Ansprüche 1 bis 8, bei dem das wenigstens eine Sensorelement und die Sichtoberfläche des Grundkörpers zumindest teilweise von einer gemeinsamen Lage eines Beschichtungsmaterials überzogen sind.

10. Sichtbauteil nach einem der Ansprüche 1 bis 9, bei dem mehr als eine induktive Spannungsversorgung zur Energetisierung des Elements zur drahtlosen Datenübertragung eingesetzt wird.

11. Verfahren zur Herstellung eines Sichtbauteils nach einem der voranstehenden Ansprüche, worin auf einen Grundkörper eine Abfolge von Schichten aufgebracht wird, wobei die Abfolge
a) eine mindestens ein Element zur drahtlosen Datenübertragung enthaltende Schicht;
b) eine mindestens eine Signalverstärkungsschaltung enthaltende Schicht;
c) eine mindestens eine Signalverarbeitungsschaltung enthaltende Schicht;
d) eine mindestens ein Sensorelement enthaltende Schicht;
e) gegebenenfalls eine mindestens einen Wellenlängenmodulator enthaltende Schicht; und
f) gegebenenfalls eine Verkapselung
umfasst.

12. Verfahren nach Anspruch 11, worin die Dicke des gesamten Schichtaufbaus auf dem Grundkörper maximal 1 bis 2 µm beträgt.

13. Verfahren nach Anspruch 11 oder 12, worin die Dicke jeder einzelnen Schicht weniger als 1 µm beträgt.

14. Verfahren nach einem der Ansprüche 11 bis 13, worin zur Verkapselung das Sichtbauteil mit einem Deck- und/oder Klarlack der Fahrzeuglackierung überzogen wird.

## Claims

1. Visible component for a motor vehicle, comprising a base body with a visible surface and at least one sensor element on the visible surface of the base body, the at least one sensor element being electrically connected to an element adjoining the at least one sensor element for wireless data transmission, by which measurement data from the sensor element can be transmitted wirelessly to an evaluation unit, **characterized in that** the at least one sensor element is connected to the element for wireless data transmission via amplification and/or preprocessing circuits, and the element for wireless data transmission can be energized by an inductive activation element, and **in that** layers are applied to the base body with the sequence comprising:
a) a layer containing at least one element for wireless data transmission;
b) a layer containing at least one signal amplification circuit;
c) a layer containing at least one signal processing circuit;
d) a layer containing at least one sensor element;
e) optionally a layer containing at least one wavelength modulator; and
f) optionally an encapsulation.

2. Visible component according to claim 1, wherein the element for wireless data transmission is printed on the visible surface of the base body or on a carrier film which is arranged on the visible surface.

3. Visible component according to claim 2, wherein the carrier film is a self-adhesive or magnetic film.

4. Visible component according to any one of claims 1 to 3, wherein the element for wireless data transmission is a passive RFID transponder.

5. Visible component according to claim 4, wherein the passive RFID transponder is integrated under the at least one sensor element as a printed circuit.

6. Visible component according to any one of claims 1 to 5, wherein the at least one sensor element is provided for receiving radiation.

7. Visible component according to any one of claims 1 to 6, wherein the at least one sensor element is constructed as an OLED and comprises 3 to 5 layers.

8. Visible component according to any one of claims 1 to 7, which comprises at least two sensor elements which are set up for receiving radiation of different wavelength ranges.

9. Visible component according to any one of claims 1 to 8, wherein the at least one sensor element and the visible surface of the base body are at least partially covered by a common layer of a coating material.

10. Visible component according to any one of claims 1 to 9, wherein more than one inductive voltage supply is used to energize the element for wireless data transmission.

11. Method for producing a visible component according to any one of the preceding claims, wherein a sequence of layers is applied to a base body, wherein the sequence comprises
a) a layer containing at least one element for wireless data transmission;
b) a layer containing at least one signal amplification circuit;
c) a layer containing at least one signal processing circuit;
d) a layer containing at least one sensor element;
e) optionally a layer containing at least one wavelength modulator; and
f) optionally an encapsulation.

12. Method according to claim 11, wherein the thickness of the entire layer structure on the base body is at most 1 to 2 µm.

13. Method according to claim 11 or 12, wherein the thickness of each individual layer is less than 1 µm.

14. Method according to any one of claims 11 to 13, wherein the visible component is coated with a top coat and/or clear coat of the vehicle paintwork for encapsulation.

## Revendications

1. Composant visible pour un véhicule à moteur, comprenant un corps de base avec une surface visible et au moins un élément capteur sur la surface visible du corps de base, dans lequel l'au moins un élément capteur est électriquement relié à un élément de transmission de données sans fil contigu à l'au moins un élément capteur, élément par lequel des données de mesure de l'élément capteur peuvent être transmises sans fil à une unité d'évaluation, **caractérisé en ce que** l'au moins un élément capteur est relié à l'élément de transmission de données sans fil par le biais de circuits d'amplification et/ou de prétraitement, et l'élément de transmission de données sans fil peut être alimenté en énergie par un élément d'activation inductif, et **en ce que** des couches sont appliquées sur le corps de base avec la séquence comprenant
a) une couche contenant au moins un élément de transmission de données sans fil ;
b) une couche contenant au moins un circuit d'amplification de signal ;
c) une couche contenant au moins un circuit de traitement de signal ;
d) une couche contenant au moins un élément capteur ;
e) éventuellement une couche contenant au moins un modulateur de longueur d'onde ; et
f) éventuellement un encapsulage.

2. Composant visible selon la revendication 1, pour lequel l'élément de transmission de données sans fil est imprimé sur la surface visible du corps de base ou sur un film porteur qui est agencé sur la surface visible.

3. Composant visible selon la revendication 2, pour lequel le film porteur est un film autocollant ou magnétique.

4. Composant visible selon l'une quelconque des revendications 1 à 3, pour lequel l'élément de transmission de données sans fil est un transpondeur RFID passif.

5. Composant visible selon la revendication 4, pour lequel le transpondeur RFID passif est intégré comme circuit imprimé sous l'au moins un élément capteur.

6. Composant visible selon l'une quelconque des revendications 1 à 5, pour lequel l'au moins un élément capteur est prévu pour la réception d'un rayonnement.

7. Composant visible selon l'une quelconque des revendications 1 à 6, pour lequel l'au moins un élément capteur est construit comme une OLED et comprend 3 à 5 couches.

8. Composant visible selon l'une quelconque des revendications 1 à 7 qui comprend au moins deux éléments capteurs qui sont conçus pour la réception d'un rayonnement de différentes plages de longueur d'onde.

9. Composant visible selon l'une quelconque des revendications 1 à 8, pour lequel l'au moins un élément capteur et la surface visible du corps de base sont recouverts au moins partiellement par une couche commune d'un matériau de revêtement.

10. Composant visible selon l'une quelconque des revendications 1 à 9, pour lequel plus d'une alimentation en tension inductive est utilisée pour l'alimentation en énergie de l'élément de transmission de données sans fil.

11. Procédé de fabrication d'un composant visible selon l'une quelconque des revendications précédentes, dans lequel une suite de couches est appliquée sur un corps de base, dans lequel la séquence comprend
a) une couche contenant au moins un élément de transmission de données sans fil ;
b) une couche contenant au moins un circuit d'amplification de signal ;
c) une couche contenant au moins un circuit de traitement de signal ;
d) une couche contenant au moins un élément capteur ;
e) éventuellement une couche contenant au moins un modulateur de longueur d'onde ; et
f) éventuellement un encapsulage.

12. Procédé selon la revendication 11, dans lequel l'épaisseur de la structure de couche entière sur le corps de base s'élève au maximum à 1 à 2 µm.

13. Procédé selon la revendication 11 ou 12, dans lequel l'épaisseur de chaque couche individuelle s'élève à moins de 1 µm.

14. Procédé selon l'une quelconque des revendications 11 à 13, dans lequel le composant visible est revêtu avec une laque de finition et/ou transparente de laquage de véhicule pour l'encapsulage.
